# EUROPEAN PATENT APPLICATION

(11) **EP 3 171 398 A1**
(43) Date of publication of application: **24.05.2017**
(21) Application number: 14861186.6
(22) Date of filing: 25.08.2014
(51) Int. Cl.: H01L 21/77

(54) **ARRAY SUBSTRATE AND MANUFACTURING METHOD THEREFOR, AND DISPLAY APPARATUS**

(30) Priority: 28.05.2014 CN 201410232647
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: SUN, Jian, Beijing 100176 (CN); CHEN, Pengjun, Beijing 100176 (CN); LI, Cheng, Beijing 100176 (CN); AN, Seongjun, Beijing 100176 (CN)
(74) Representative: Fritzsche, Thomas
(86) International application number: PCT/CN2014/085088
(87) International publication number: WO 2015/180269

(57) **Abstract**

An array substrate, a method for fabricating the same, and a display device are provided. A metal shielding layer is electrically connected with a common electrode. A first connection part used for electrically connecting the metal shielding layer and the common electrode is arranged in the same layer as a source/drain electrode, and is electrically connected with the metal shielding electrode by means of a via penetrating the first insulating layer and the buffer layer. A storage capacitor is formed between an active layer and the metal shielding layer, increasing capacitance of the array substrate. The first connection part and the source/drain electrode which are arranged in the same layer can be formed by performing a patterning process for one time, thus reducing the fabricating flow, simplifying the fabricating process, saving the fabricating cost, and decreasing the fabricating time.

## Description

### Related Application(s)

The present application claims the benefit of Chinese Patent Application No. 201410232647.7, filed May 28, 2014, the entire disclosure of which is incorporated herein by reference.

### FIELD OF THE INVENTION

The present disclosure relates to the field of display technology, and particularly to an array substrate, a method for fabricating the same, and a display device.

### BACKGROUND ART

Inherent drawbacks of amorphous silicon lead to a device with low on-state current, low mobility, and poor stability, and thus is hindered from being applied in several fields. LTPS (low temperature poly-crystalline silicon) has emerged to overcome inherent drawbacks of amorphous silicon and thus increase the application field.

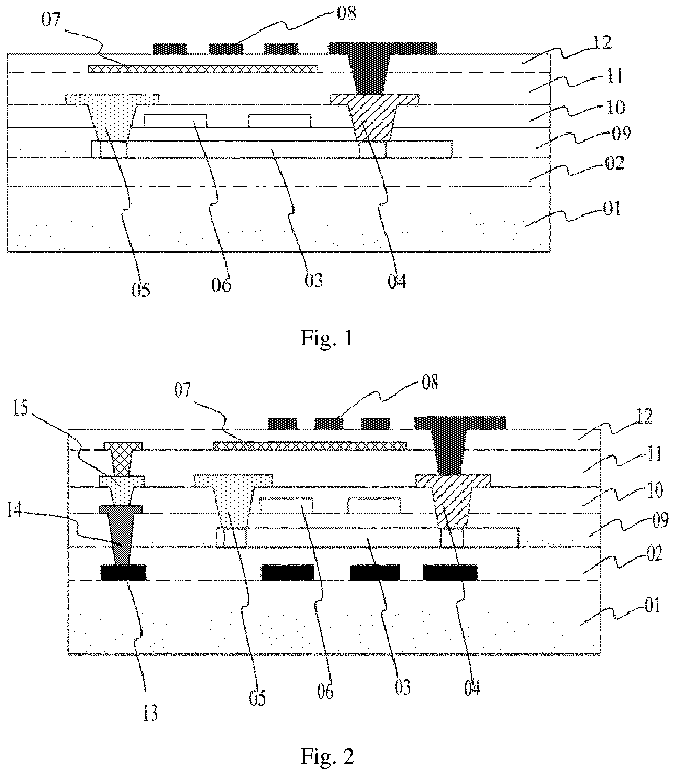

With the development of Thin Film Transistor Liquid Crystal Display (TFT-LCD) technology, LTPS-based display technology has gradually become mainstream. As shown in Fig. 1 and Fig. 2, a LTPS thin film transistor array substrate in the prior art mainly comprises: a substrate 01, a buffer layer 02, an active layer 03, a gate electrode 06, a source electrode 05, a drain electrode 04, a common electrode 07, a pixel electrode 08, a gate insulating layer 09, an intermediate dielectric layer 10, a planarization layer 11, and a passivation layer 12. In an array substrate with a top-gate thin film transistor, as shown in Fig. 2, in order to prevent light from being incident on the active layer 03 and thus affecting the performance of the thin film transistor, a metal shielding layer 13 is further arranged between the buffer layer 02 and the active layer 03 to avoid light from being incident on the active layer 03.

As required by development of the pixel technology, an important issue is how to increase storage capacitance. In order to increase storage capacitance in the prior art, as shown in Fig. 2, in an array substrate with a top-gate thin film transistor, a storage capacitor is formed between the metal shielding layer 13 under the buffer layer 02 and the active layer 03 to increase storage capacitance. In particular, in order to apply a common electrode signal to the metal shielding layer 13, the metal shielding layer 13 should be electrically connected with the common electrode 07 by means of a first connection part 14 on the gate insulating layer 09 and a second connection part 15 on the intermediate dielectric layer 10. The first connection part 14 is electrically connected with the metal shielding layer 13 by means of a via penetrating the gate insulating layer 09 and the buffer layer 02, the connection part 15 is electrically connected with the first connection part 14 by means of a via penetrating the intermediate dielectric layer 10, and the common electrode 07 is electrically connected with the second connection part 15 by means of a via penetrating planarization layer 11.

In the above-mentioned LTPS thin film transistor array substrate, a storage capacitor can be formed by means of the metal shielding layer and the active layer. However, for the purpose that the metal shielding layer 13 is electrically connected with the common electrode 07 to form the storage capacitor by the metal shielding layer 13 and the active layer 03, an additional mask process is needed to form a via penetrating the gate insulating layer 09 and the buffer layer 02, so that the first connection part 14, which is used for electrically connecting the common electrode 07 and the metal shielding layer 13, is electrically connected with the metal shielding layer 13 by means of the via. As a result, the process for fabricating the above-mentioned LTPS thin film transistor array substrate is complicated in flow, high in cost, and long in duration.

### SUMMARY

The present disclosure provides an array substrate, a method for fabricating the same, and a display device, which can solve or at least partially alleviate one or more problems in the prior art.

The present disclosure provides an array substrate, comprising a substrate, and a metal shielding layer, a buffer layer, a top-gate thin film transistor, and a common electrode which are arranged on the substrate successively; wherein in the top-gate thin film transistor, a source/drain electrode is arranged over an active layer and is electrically connected with the active layer by means of a first via penetrating a first insulating layer between the source/drain electrode and the active layer, wherein the array substrate further comprises:
a first connection part which is arranged in the same layer as the source/drain electrode, is used for electrically connecting the metal shielding layer and the common electrode, and is electrically connected with the metal shielding layer by means of a second via penetrating the first insulating layer and the buffer layer.

In the above array substrate of the present disclosure, the metal shielding layer is electrically connected with the common electrode. Besides, the first connection part used for electrically connecting the metal shielding layer and the common electrode is arranged in the same layer as the source/drain electrode, and is electrically connected with the metal shielding electrode by means of a via penetrating the first insulating layer and the buffer layer. In this manner, the present array substrate can form a storage capacitor between the active layer and the metal shielding layer, thus increasing capacitance of the array substrate. In addition, the first connection part and the source/drain electrode which are arranged in the same layer can be formed by performing a patterning process for one time, thus reducing the fabricating flow, simplifying the fabricating process, saving the fabricating cost, and decreasing the fabricating time.

For purpose of facilitating implementation, the present array substrate can further comprise a second insulating layer which is arranged between the source/drain electrode and the common electrode, wherein the common electrode is electrically connected with the first connection part by means of a third via penetrating the second insulating layer.

For purpose of facilitating implementation, the present array substrate can further comprise: a pixel electrode which is arranged over the common electrode, a third insulating layer which is arranged between the pixel electrode and the common electrode, and a second connection part which is arranged in the same layer as the common electrode and is used for electrically connecting the pixel electrode and a drain electrode of the source/drain electrode,
wherein the second connection part is electrically connected with a drain electrode of the source/drain electrode by means of a fourth via penetrating the second insulating layer, and the pixel electrode is electrically connected with the second connection part by means of a fifth via penetrating the third insulating layer.

For purpose of facilitating implementation, the present array substrate can further comprise: a pixel electrode which is arranged between the source/drain electrode and the common electrode and is insulated from the common electrode, and a second insulating layer which is arranged between the pixel electrode and the source/drain electrode,
wherein the pixel electrode is electrically connected with a drain electrode of the source/drain electrode by means of a sixth via penetrating the second insulating layer.

For purpose of facilitating implementation, the present array substrate can further comprise: a third insulating layer which is arranged between the pixel electrode and the common electrode, and a third connection part which is arranged in the same layer as the pixel electrode and is used for electrically connecting the common electrode and the first connection part,
wherein the third connection part is electrically connected with the first connection part by means of a seventh via penetrating the second insulating layer, and the common electrode is electrically connected with the third connection part by means of an eighth via penetrating the third insulating layer.

The present disclosure provides a display device which comprises any one of the array substrate as mentioned above.

The present disclosure provides a method for fabricating an array substrate, comprising forming an a substrate successively patterns of a metal shielding layer, a buffer layer, a top-gate thin film transistor, and a common electrode; wherein in the top-gate thin film transistor, a source/drain electrode is arranged over an active layer and is electrically connected with the active layer by means of a first via penetrating a first insulating layer between the source/drain electrode and the active layer, wherein the method further comprises:
at the same time as forming the first via penetrating the first insulating layer, forming a second via penetrating the first insulating layer and the buffer layer by means of a half tone mask plate or a gray tone mask plate; and
at the same time as forming a pattern of the source/drain electrode, forming, by performing a patterning process for one time, a pattern of a first connection part which is used for electrically connecting the metal shielding layer and the common electrode and is electrically connected with the metal shielding layer by means of the second via.

In the above mentioned method, at the same time as forming the first via penetrating the first insulating layer, the second via penetrating the first insulating layer and the buffer layer is formed by means of a half tone mask plate or a gray tone mask plate. At the same time as forming the pattern of the source/drain electrode, the pattern of the first connection part, which is used for electrically connecting the metal shielding layer and the common electrode and is electrically connected with the metal shielding layer by means of the second via, is formed by performing a patterning process for one time. Therefore, as compared with the prior art in which the metal shielding layer and the common electrode are electrically connected with each other by means of a first connection part and a second connection part on the first connection part, a mask process which separately forms a via for electrically connecting a first connection part and a metal shielding layer can be omitted in the present method. Therefore, the present method can reduce the fabricating flow, simplify the fabricating process, save the fabricating cost, and decrease the fabricating time.

For purpose of facilitating implementation, after forming the pattern of the source/drain electrode, and before forming the pattern of the common electrode, the present method can further comprise:
forming a thin film for a second insulating layer between the source/drain electrode and the common electrode to be formed; and
forming a third via penetrating the thin film of the second insulating layer by performing a patterning process, wherein the common electrode is electrically connected with the first connection part by means of the third via.

To simplify the fabricating process, save the fabricating cost, and decrease the production cycle, the present method can further comprise:
at the same time as forming the third via, forming, by performing a patterning process for one time, a fourth via penetrating the second insulating layer;
at the same time as forming the pattern of the common electrode, forming, by performing a patterning process for one time, a pattern of a second connection part which is used for electrically connecting a pixel electrode to be formed and a drain electrode in the source/drain electrode, wherein the second connection part is electrically connected with the drain electrode by means of the fourth via;
after forming the pattern of the common electrode, the method further comprises:
   forming a thin film of a third insulating layer on the common electrode;
   forming a fifth via penetrating the thin film of the third insulating layer by performing a patterning process; and
   forming a pattern of the pixel electrode on the third insulating layer, wherein the pixel electrode is electrically connected with the second connection part by means of the fifth via.

For purpose of facilitating implementation, after forming the pattern of the source/drain electrode, and before forming the pattern of the common electrode, the present method can further comprise:
forming a thin film for a second insulating layer between the source/drain electrode and the common electrode to be formed;
forming, by performing a patterning process, a sixth via penetrating the thin film of the second insulating layer; and
forming a pattern of a pixel electrode on the thin film of the second insulating layer in which the sixth via has been formed, wherein the pixel electrode is electrically connected with a drain electrode in the source/drain electrode by means of the sixth via.

To simplify the fabricating process, save the fabricating cost, and decrease the production cycle, the present method can further comprise:
at the same time as forming the sixth via, forming, by performing a patterning process for one time, a seventh via penetrating the second insulating layer; and
at the same time as forming the pattern of the pixel electrode, forming, by performing a patterning process for one time, a pattern of a third connection part which is used for electrically connecting the common electrode to be formed and the first connection part, wherein the third connection part is electrically connected with the first connection part by means of the seventh via;
after forming the pattern of the pixel electrode, the method further comprises:
   forming a thin film of a third insulating layer between the pixel electrode and the common electrode to be formed; and
   forming, by performing a patterning process, an eighth via penetrating the thin film of the third insulating layer, wherein the common electrode to be formed is electrically connected with the third connection part by means of the eighth via.

### BRIEF DESCRIPTION OF DRAWINGS

Fig. 1 is a structural view of a LTPS thin film transistor array substrate in the prior art.
Fig. 2 is another structural view of a LTPS thin film transistor array substrate in the prior art.
Fig. 3a and Fig. 3b are structural views of an array substrate in the present disclosure, respectively.
Fig. 4 is a top view of the array substrate shown in Fig. 3a.
Figs. 5a, 5b, 5c, 5d, 5e, 5f, 5g, 5h, 5i, 5j, and 5k are structural views of an array substrate after each step of a method in Example 1 of the present disclosure.
Figs. 6a, 6b, and 6c are structural views of an array substrate after each step of a method in Example 2 of the present disclosure.

### DETAILED DESCRIPTION OF EMBODIMENTS

The following description is presented to enable any person skilled in the art to make and use the invention, and is provided in the context of a particular application and its requirements. Various modifications to the disclosed embodiments will be readily apparent to those skilled in the art, and the general principles defined herein may be applied to other embodiments and applications without departing from the spirit and scope of the present invention. Thus, the present invention is not limited to the embodiments shown, but is to be accorded the widest scope consistent with the claims.

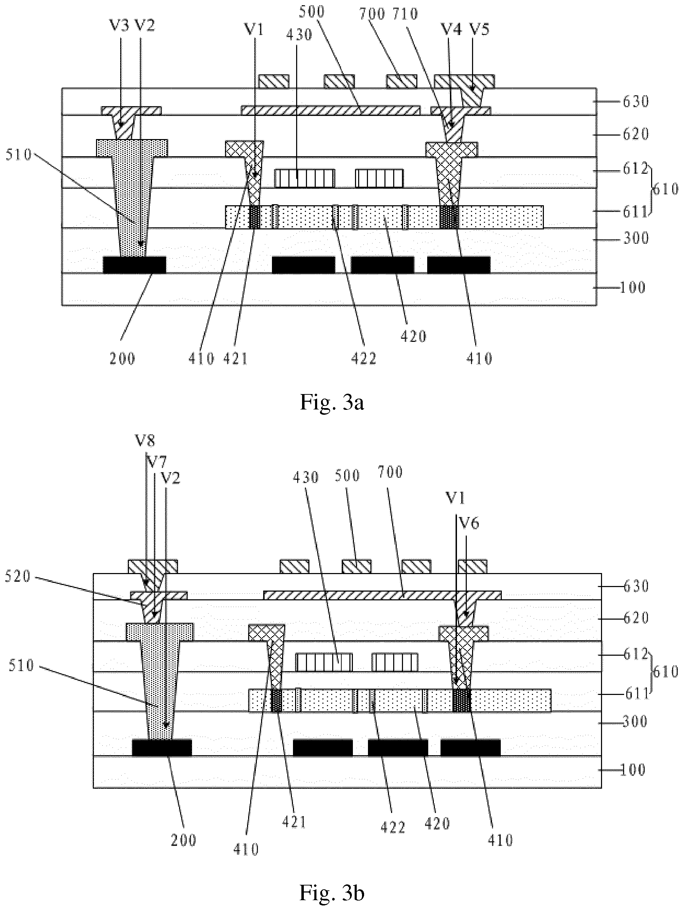

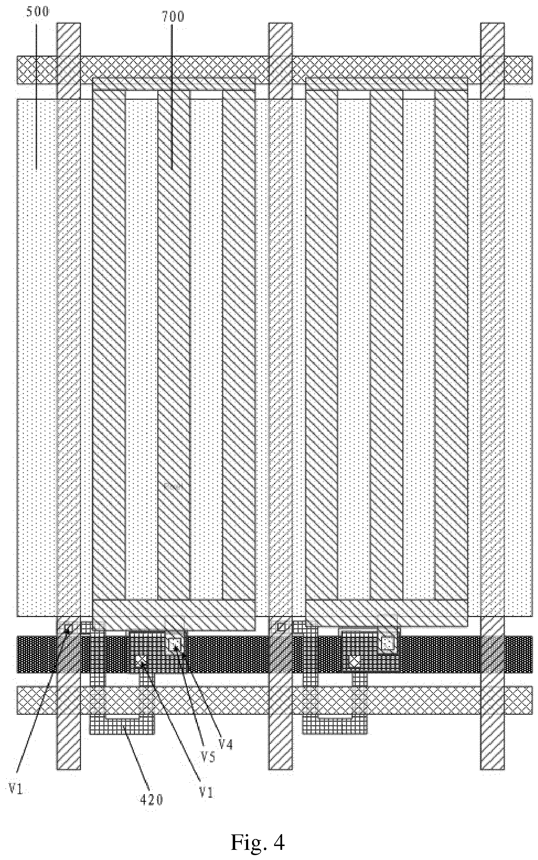

An array substrate of the present disclosure, as shown in Fig. 3a, Fig. 3b, and Fig. 4 (a top view of the array substrate shown in Fig. 3a), comprises a substrate 100, and a metal shielding layer 200, a buffer layer 300, a top-gate thin film transistor, and a common electrode 500 which are arranged on the substrate 100 successively. A source/drain electrode 410 of the top-gate thin film transistor is arranged over an active layer 420, and is electrically connected with the active layer 420 by means of a first via V1 penetrating a first insulating layer 610 between the source/drain electrode 410 and the active layer 420. The array substrate further comprises a first connection part 510, which is arranged in the same layer as the source/drain electrode 410, is used for electrically connecting the metal shielding layer 200 and the common electrode 500, and is electrically connected with the metal shielding layer 200 by means of a second via V2 penetrating the first insulating layer 610 and the buffer layer 300.

In the above array substrate of the present disclosure, the metal shielding layer is electrically connected with the common electrode. Besides, the first connection part used for electrically connecting the metal shielding layer and the common electrode is arranged in the same layer as the source/drain electrode, and is electrically connected with the metal shielding electrode by means of a via penetrating the first insulating layer and the buffer layer. In this manner, the present array substrate can form a storage capacitor between the active layer and the metal shielding layer, thus increasing capacitance of the array substrate. In addition, the first connection part and the source/drain electrode which are arranged in the same layer can be formed by performing a patterning process for one time, thus reducing the fabricating flow, simplifying the fabricating process, saving the fabricating cost, and decreasing the fabricating time.

It is noted that, in the present array substrate, as shown in Fig. 3a and Fig. 3b, an orthographic projection of the metal shielding layer 200 onto the substrate 100 at least partially overlaps an orthographic projection of the active layer 420 onto the substrate 100, so that a storage capacitor is formed between the active layer 420 and the metal shielding layer 200.

In practice of the present array substrate, the active layer can be made from LTPS or oxide, and the present disclosure is not limited in this aspect.

In the present array substrate, as shown in Fig. 3a and Fig. 3b, there can be only one gate electrode. In practice, there can be two gate electrodes 430. The purpose of providing two gate electrodes 430 is to reduce leakage current of the thin film transistor.

In the present array substrate, as shown in Fig. 3a, and Fig. 3b, the active layer 420 may comprise heavily doped regions 421 and lightly doped regions 422. The heavily doped regions 421 are arranged in the active layer 420 at regions corresponding to the source/drain electrode 410, for reducing contact resistance between the source/drain electrode 410 and the active layer 420. The lightly doped regions 422 are provided between the heavily doped regions 421, and arranged at both sides of the regions corresponding to two gate electrodes 430 in the active layer 420. The lightly doped regions 422 can reduce the leakage current in the thin film transistor. The arrangement of heavily doped regions 421 and lightly doped regions 422 as shown is only an example. In practice, in some thin film transistors, there is no heavily doped region or lightly doped region. Alternatively, there are more heavily doped regions or lightly doped regions which are arranged at different positions as required.

In particular, in the top-gate thin film transistor, the gate electrode can be arranged over the source/drain electrode, or below the source/drain electrode. Hereinafter, reference is made to a case in which the gate electrode lies below the source/drain electrode.

In particular, when the gate electrode lies below the source/drain electrode, as shown in Fig. 3a and Fig. 3b, the first insulating layer 610 between the source/drain electrode 410 and the active layer 420 refers to a gate insulating layer 611 between the active layer 420 and a gate electrode 430 and an interlayer dielectric layer 612 between the gate electrode 430 and the source/drain electrode 410. However, the present disclosure is not limited in this aspect.

The present array substrate, as shown in Fig. 3a, further comprises a second insulating layer 620 between the source/drain electrode 410 and the common electrode 500, wherein the common electrode 500 is electrically connected with the first connection part 510 by means of a third via V3 penetrating the second insulating layer 620.

For purpose of facilitating implementation, the present array substrate as shown in Fig. 3a can further comprise: a pixel electrode 700 which is arranged over the common electrode 500, a third insulating layer 630 which is arranged between the pixel electrode 700 and the common electrode 500, and a second connection part 710 which is arranged in the same layer as the common electrode 500 and is used for electrically connecting the pixel electrode 700 and a drain electrode in the source/drain electrode 410. The second connection part 710 is electrically connected with a drain electrode in the source/drain electrode 410 by means of a fourth via V4 penetrating the second insulating layer 620, and the pixel electrode 700 is electrically connected with the second connection part 710 by means of a fifth via V5 penetrating the third insulating layer 630.

In practice of the present array substrate, in case the pixel electrode is arranged over the common electrode, the pixel electrode can have a slit shape, the pixel electrode can be made from a transparent conductive material like indium tin oxide, the common electrode can have a plate shape or slit shape, and the common electrode can be made from a transparent conductive material like indium tin oxide.

For example, as shown in Fig. 3b, the array substrate can further comprise: the pixel electrode 700 which is arranged between the source/drain electrode 410 and the common electrode 500 and is insulated from the common electrode 500, and the second insulating layer 620 which is arranged between the pixel electrode 700 and the source/drain electrode 410. The pixel electrode 700 is electrically connected with the drain electrode in the source/drain electrode 410 by means of a sixth via V6 penetrating the second insulating layer 620.

As shown in Fig. 3b, the array substrate can further comprise: the third insulating layer 630 which is arranged between the pixel electrode 700 and the common electrode 500, and a third connection part 520 which is arranged in the same layer as the pixel electrode 700 and is used for electrically connecting the common electrode 500 and the first connection part 510. The third connection part 520 is electrically connected with the first connection part 510 by means of a seventh via V7 penetrating the second insulating layer 620. The common electrode 500 is electrically connected with the third connection part 520 by means of an eighth via V8 penetrating the third insulating layer 630.

In practice of the present array substrate, in case the common electrode is arranged over the pixel electrode, the common electrode can have a slit shape, the common electrode can be made from a transparent conductive material like indium tin oxide, the pixel electrode can have a plate shape or slit shape, and the pixel electrode can be made from a transparent conductive material like indium tin oxide.

It is noted that the present array substrate is described in case the top-gate TFT has an active layer of poly-crystalline silicon. However, the present disclosure is also applicable to a top-gate TFT has an active layer of amorphous silicon.

Based on the same inventive concept, the present disclosure further provides a display device which comprises the array substrate as described above. The display device can be any product or component with a display function, such as a mobile phone, a tablet computer, a television, a monitor, a notebook computer, a digital photo frame, and a navigator. It will be appreciated by the skilled in the art that the display device may comprise other essential components. Thus, these components are not described in detail herein for simplicity, and do not limit the present disclosure in any way. The display device can be implemented in a manner similar with the array substrate as mentioned above.

Based on the same inventive concept, the present disclosure further provides a method for fabricating an array substrate, comprising forming an a substrate successively patterns of a metal shielding layer, a buffer layer, a top-gate thin film transistor, and a common electrode; wherein in the top-gate thin film transistor, a source/drain electrode is arranged over an active layer and is electrically connected with the active layer by means of a first via penetrating a first insulating layer between the source/drain electrode and the active layer, wherein the method further comprises:
at the same time as forming the first via penetrating the first insulating layer, forming a second via penetrating the first insulating layer and the buffer layer by means of a half tone mask plate or a gray tone mask plate; and
at the same time as forming a pattern of the source/drain electrode, forming, by performing a patterning process for one time, a pattern of a first connection part which is used for electrically connecting the metal shielding layer and the common electrode and is electrically connected with the metal shielding layer by means of the second via.

In the above mentioned method, at the same time as forming the first via penetrating the first insulating layer, the second via penetrating the first insulating layer and the buffer layer is formed by means of a half tone mask plate or a gray tone mask plate. At the same time as forming the pattern of the source/drain electrode, the pattern of the first connection part, which is used for electrically connecting the metal shielding layer and the common electrode and is electrically connected with the metal shielding layer by means of the second via, is formed by performing a patterning process for one time. Therefore, as compared with the prior art in which the metal shielding layer and the common electrode are electrically connected with each other by means of a first connection part and a second connection part on the first connection part, a mask process which separately forms a via for electrically connecting a first connection part and a metal shielding layer can be omitted in the present method. Therefore, the present method can reduce the fabricating flow, simplify the fabricating process, save the fabricating cost, and decrease the fabricating time.

It is noted that in the present method, the patterning process can only comprise photolithographic process. Alternatively, the patterning process can comprise photolithographic process and etching steps. In addition, the patterning process can further comprise a process for forming a predefined pattern, like printing, ink-jetting. The photolithographic process refers to a process which comprises forming a film, exposing, developing and forms the pattern by means of photoresist, mask plate, exposure machine. In practice, a patterning process can be selected according to the structure to be formed in the present disclosure.

The present method can further comprise: forming a thin film for a second insulating layer between the source/drain electrode and the common electrode to be formed; and forming a third via penetrating the thin film of the second insulating layer by performing a patterning process, wherein the common electrode is electrically connected with the first connection part by means of the third via.

To simplify the fabricating process, save the fabricating cost, and decrease the production cycle, the present method can further comprise: at the same time as forming the third via, forming, by performing a patterning process for one time, a fourth via penetrating the second insulating layer; at the same time as forming the pattern of the common electrode, forming, by performing a patterning process for one time, a pattern of a second connection part which is used for electrically connecting a pixel electrode to be formed and a drain electrode in the source/drain electrode, wherein the second connection part is electrically connected with the drain electrode by means of the fourth via;
after forming the pattern of the common electrode, the method further comprises: forming a thin film of a third insulating layer on the common electrode; forming a fifth via penetrating the thin film of the third insulating layer by performing a patterning process; and forming a pattern of the pixel electrode on the third insulating layer, wherein the pixel electrode is electrically connected with the second connection part by means of the fifth via

Alternatively, after forming the pattern of the source/drain electrode, and before forming the pattern of the common electrode, the present method can further comprise: forming a thin film for a second insulating layer between the source/drain electrode and the common electrode to be formed; forming, by performing a patterning process, a sixth via penetrating the thin film of the second insulating layer; and forming a pattern of a pixel electrode on the thin film of the second insulating layer in which the sixth via has been formed, wherein the pixel electrode is electrically connected with a drain electrode in the source/drain electrode by means of the sixth via.

To simplify the fabricating process, save the fabricating cost, and decrease the production cycle, the present method can further comprise: at the same time as forming the sixth via, forming, by performing a patterning process for one time, a seventh via penetrating the second insulating layer; and at the same time as forming the pattern of the pixel electrode, forming, by performing a patterning process for one time, a pattern of a third connection part which is used for electrically connecting the common electrode to be formed and the first connection part, wherein the third connection part is electrically connected with the first connection part by means of the seventh via;
after forming the pattern of the pixel electrode, the method further comprises: forming a thin film of a third insulating layer between the pixel electrode and the common electrode to be formed; and forming, by performing a patterning process, an eighth via penetrating the thin film of the third insulating layer, wherein the common electrode to be formed is electrically connected with the third connection part by means of the eighth via.

It is noted that reference has been made to a top-gate LTPS TFT with two gates. It will be appreciated that the present disclosure is also applicable to amorphous silicon TFT or oxide TFT which has a single gate and of the top-gate type. All solutions which can increase the storage capacitance of the array substrate by increasing a confronting area between the active layer and the metal shielding layer fall within the scope of the present disclosure.

In particular, the method for fabricating an array substrate will be described by referring to an array substrate shown in Fig. 3a and Fig. 3b.

### Example 1:

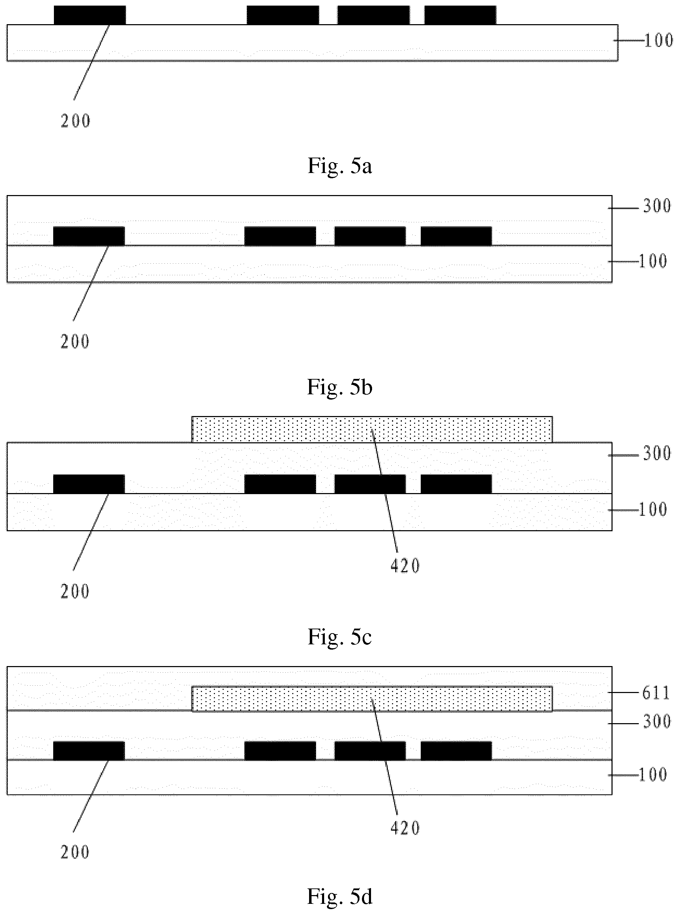

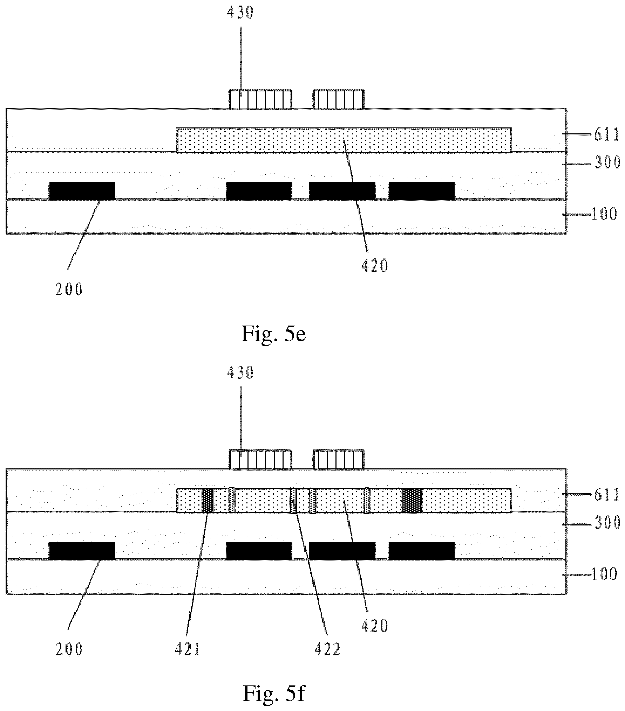

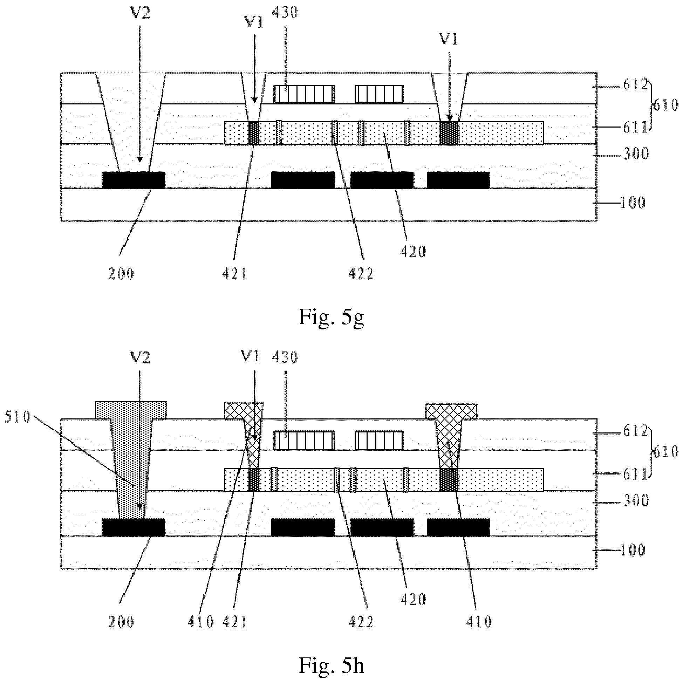

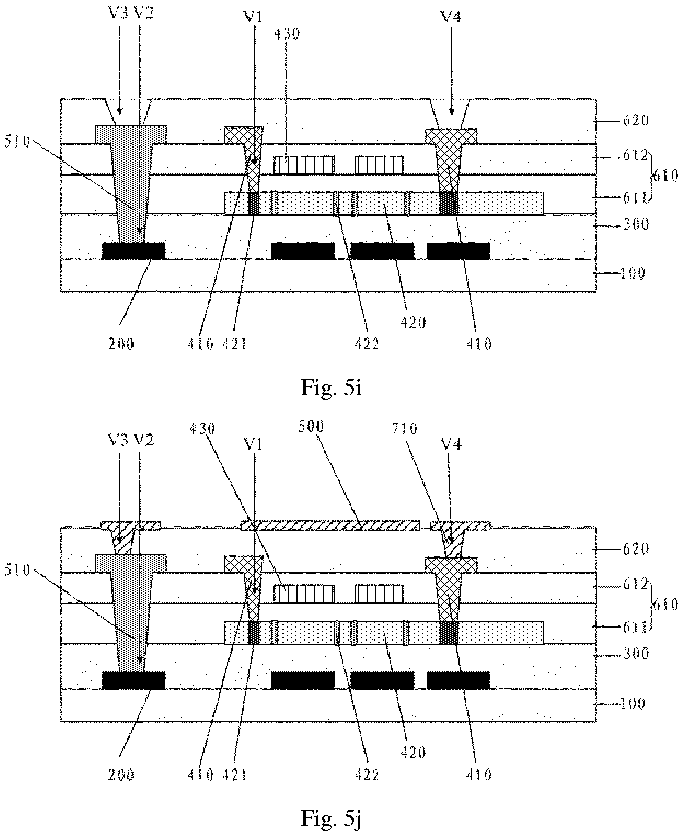

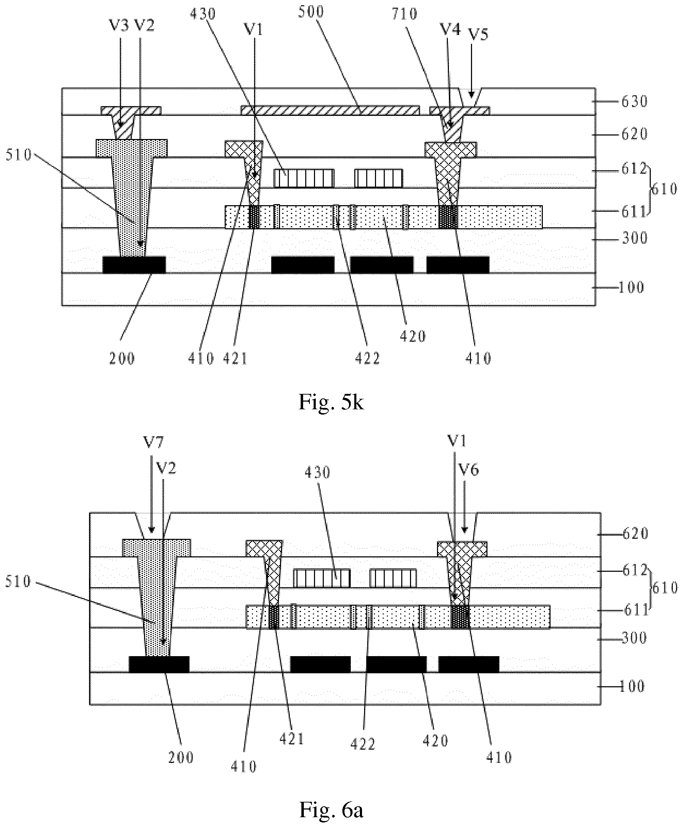

As shown in Fig. 3a, the pixel electrode 700 in the array substrate is arranged over the common electrode 500. The process for fabricating the array substrate may comprise the following steps.
(1) A pattern of the metal shielding layer 200 is formed on the substrate 100, as shown in Fig. 5a.
(2) A buffer layer 300 is formed on the metal shielding layer 200, as shown in Fig. 5b.
   In practice, the buffer layer can be deposited by plasma enhanced chemical vapor deposition. The buffer layer can be made from silicon dioxide or silicon nitride.
(3) A pattern of an active layer 420 is formed on the buffer layer 300, as shown in Fig. 5c.
   In practice, a thin film of amorphous silicon is formed over the buffer layer by plasma enhanced chemical vapor deposition or similar methods. The amorphous silicon is crystallized by laser annealing process or solid phase crystallization process to form a poly-crystalline silicon thin film. The poly-crystalline silicon thin film is formed into a pattern comprising a LTPS active layer by a patterning process.
(4) A gate insulating layer 611 is formed on the active layer 420, as shown in Fig. 5d.
   In practice, the gate insulating layer can be made from silicon oxide or silicon nitride.
(5) A pattern of the gate electrode 430 is formed on the gate insulating layer 611, as shown in Fig. 5e.
   In practice, the gate electrode can be made from a metal like molybdenum (Mo), aluminum (Al), or chromium (Cr).
(6) Heavily doped regions 421 and lightly doped regions 422 are formed in the active layer 420, as shown in Fig. 5f.
   In practice, the active layer is heavily doped at both sides by ion implantation to form the heavily doped regions, and a portion of the active layer between the heavily doped regions is lightly doped to form the lightly doped regions. The lightly doped regions are arranged at both sides of a region corresponding to the gate electrode. During ion implantation, regions can be doped to different concentrations by ion implantation with a mask plate. Alternatively, the ion implantation can be performed by utilizing the pattern of the gate electrode for shielding, or by utilizing a photoresist in a patterning process for shielding, which is similar with the prior art and is omitted here for simplicity.
(7) An interlayer dielectric layer 612 is formed on the gate electrode 430, and a first via V1 penetrating the interlayer dielectric layer 612 and a gate insulating layer 611 and a second via V2 penetrating the interlayer dielectric layer 612, the gate insulating layer 611, and the buffer layer 300 are formed by means of a half tone mask plate or a gray tone mask plate, as shown in Fig. 5g.
   In practice, a partially transparent region of the half tone mask plate or the gray tone mask plate corresponds to a region of the first via, and the completely transparent region corresponds to a region of the second via.
   In practice, the interlayer dielectric layer can be made from silicon oxide or silicon nitride, and the present disclosure does not intend to be limited in this aspect.
(8) A pattern of a source/drain electrode 410 and a first connection part 510 is formed on the interlayer dielectric layer 612, as shown in Fig. 5h.
   In practice, a thin film of the source/drain electrode can be formed on the interlayer dielectric layer. By performing a patterning process for one time, the pattern of the source/drain electrode and the first connection part can be formed in the thin film of the source/drain electrode. The source/drain electrode is electrically connected with the active layer by means of the first via, and the first connection part is electrically connected with the metal shielding layer by means of the second via.
(9) A thin film of a second insulating layer 620 is formed on the source/drain electrode 410, and a third via V3 and a fourth via V4 penetrating the second insulating layer 620 are formed by performing a patterning process for one time, as shown in Fig. 5i.
(10) A thin film of the common electrode 500 is formed on the second insulating layer 620. A pattern of the common electrode 500 and a second connection part 710 are formed in the thin film of the common electrode 500, by performing a patterning process for one time, as shown in Fig. 5j.
   In practice, the common electrode can have a plate shape or slit shape, the common electrode can be made from a transparent conductive material like indium tin oxide, the common electrode is electrically connected with the first connection part by means of the third via, and the second connection part is electrically connected with the drain electrode in the source/drain electrode by means of the fourth via.
(11) A third insulating layer 630 is formed on the common electrode 500. A fifth via V5 penetrating the third insulating layer 630 is formed by performing a patterning process, as shown in Fig. 5k.
(12) A pattern of the pixel electrode 700 is formed on the third insulating layer 630, as shown in Fig. 3a.

In practice, the pixel electrode can have a slit shape, the pixel electrode can be made from a transparent conductive material like indium tin oxide, and the pixel electrode is electrically connected with the second connection part by means of the fifth via.

In particular, as a result of the above steps (1)-(12), the array substrate of the present disclosure is obtained. In particular, a structural view of the resultant array substrate is shown in Fig. 3a.

### Example 2:

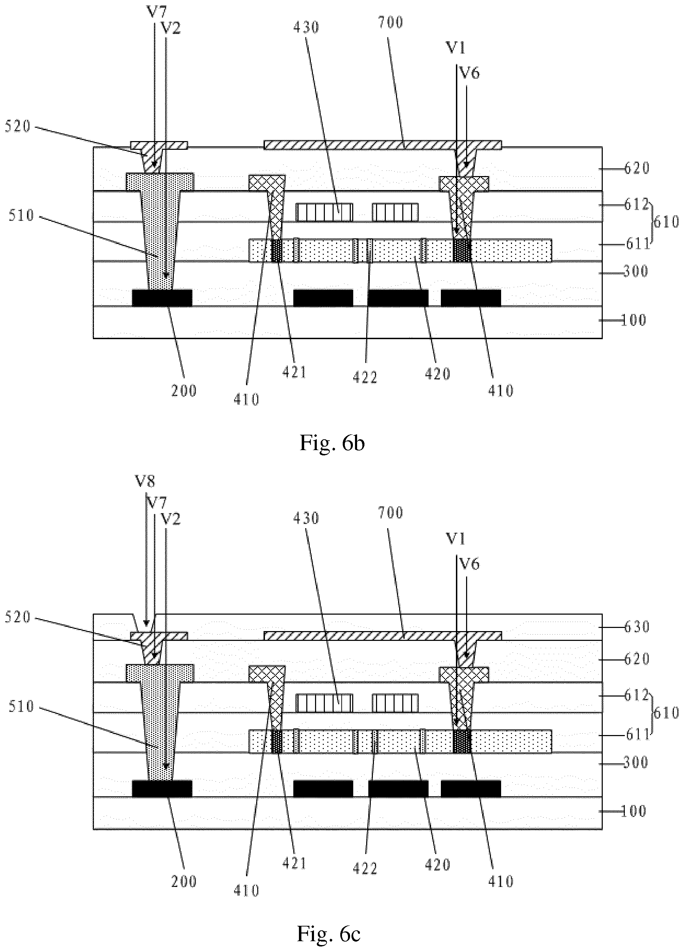

As shown in Fig. 3b, in the array substrate, the common electrode 500 is arranged over the pixel electrode 700. Apart from the above steps (1)-(8), the fabricating process of the array substrate further comprises the following steps.
(9') A thin film of the second insulating layer 620 is formed on the source/drain electrode 410. The sixth via V6 and the seventh via V7 penetrating the second insulating layer 620 are formed by performing a patterning process for one time, as shown in Fig. 6a.
(10') A thin film of the pixel electrode 700 is formed on the second insulating layer 620. The pattern of the pixel electrode 700 and the third connection part 520 is formed in the thin film of the pixel electrode 700 by performing a patterning process for one time, as shown in Fig. 6b.
   In practice, the pixel electrode can have a plate shape or slit shape, the pixel electrode can be made from a transparent conductive material like indium tin oxide, the pixel electrode is electrically connected with the drain electrode in the source/drain electrode by means of the sixth via, and the third connection part is electrically connected with the first connection part by means of the seventh via.
(11') A third insulating layer 630 is formed on the pixel electrode 700. An eighth via V8 penetrating the third insulating layer 630 is formed by performing a patterning process, as shown in Fig. 6c.
(12') A pattern of the common electrode 500 is formed on the third insulating layer 630, as shown in Fig. 3b.

In practice, the common electrode can have a slit shape, the common electrode can be made from a transparent conductive material like indium tin oxide, and the common electrode is electrically connected with the third connection part by means of the eighth via.

In particular, as a result of the above steps (1)-(8) and (9')-(12'), the array substrate of the present disclosure is obtained. In particular, a structural view of the resultant array substrate is shown in Fig. 3b.

The present disclosure provides an array substrate, a method for fabricating the same, and a display device. The metal shielding layer is electrically connected with the common electrode. Besides, the first connection part used for electrically connecting the metal shielding layer and the common electrode is arranged in the same layer as the source/drain electrode, and is electrically connected with the metal shielding electrode by means of a via penetrating the first insulating layer and the buffer layer. In this manner, the present array substrate can form a storage capacitor between the active layer and the metal shielding layer, thus increasing capacitance of the array substrate. In addition, the first connection part and the source/drain electrode which are arranged in the same layer can be formed by performing a patterning process for one time, thus reducing the fabricating flow, simplifying the fabricating process, saving the fabricating cost, and decreasing the fabricating time.

The scope of the disclosure is defined by the appended claims rather than by the description, and all variations that fall within the range of the claims are intended to be embraced therein. Thus, other embodiments than the specific ones described above are equally possible within the scope of these appended claims.

## Claims

1. An array substrate, comprising a substrate, and a metal shielding layer, a buffer layer, a top-gate thin film transistor, and a common electrode which are arranged on the substrate successively; wherein in the top-gate thin film transistor, a source/drain electrode is arranged over an active layer and is electrically connected with the active layer by means of a first via penetrating a first insulating layer between the source/drain electrode and the active layer, wherein the array substrate further comprises:
a first connection part which is arranged in the same layer as the source/drain electrode, is used for electrically connecting the metal shielding layer and the common electrode, and is electrically connected with the metal shielding layer by means of a second via penetrating the first insulating layer and the buffer layer.

2. The array substrate of claim 1, further comprising a second insulating layer which is arranged between the source/drain electrode and the common electrode, wherein the common electrode is electrically connected with the first connection part by means of a third via penetrating the second insulating layer.

3. The array substrate of claim 2, further comprising: a pixel electrode which is arranged over the common electrode, a third insulating layer which is arranged between the pixel electrode and the common electrode, and a second connection part which is arranged in the same layer as the common electrode and is used for electrically connecting the pixel electrode and a drain electrode of the source/drain electrode,
wherein the second connection part is electrically connected with a drain electrode of the source/drain electrode by means of a fourth via penetrating the second insulating layer, and the pixel electrode is electrically connected with the second connection part by means of a fifth via penetrating the third insulating layer.

4. The array substrate of claim 1, further comprising: a pixel electrode which is arranged between the source/drain electrode and the common electrode and is insulated from the common electrode, and a second insulating layer which is arranged between the pixel electrode and the source/drain electrode,
wherein the pixel electrode is electrically connected with a drain electrode of the source/drain electrode by means of a sixth via penetrating the second insulating layer.

5. The array substrate of claim 4, further comprising: a third insulating layer which is arranged between the pixel electrode and the common electrode, and a third connection part which is arranged in the same layer as the pixel electrode and is used for electrically connecting the common electrode and the first connection part,
wherein the third connection part is electrically connected with the first connection part by means of a seventh via penetrating the second insulating layer, and the common electrode is electrically connected with the third connection part by means of an eighth via penetrating the third insulating layer.

6. A display device, comprising the array substrate of claim 1.

7. A method for fabricating an array substrate, comprising forming an a substrate successively patterns of a metal shielding layer, a buffer layer, a top-gate thin film transistor, and a common electrode; wherein in the top-gate thin film transistor, a source/drain electrode is arranged over an active layer and is electrically connected with the active layer by means of a first via penetrating a first insulating layer between the source/drain electrode and the active layer, wherein the method further comprises:
at the same time as forming the first via penetrating the first insulating layer, forming a second via penetrating the first insulating layer and the buffer layer by means of a half tone mask plate or a gray tone mask plate; and
at the same time as forming a pattern of the source/drain electrode, forming, by performing a patterning process for one time, a pattern of a first connection part which is used for electrically connecting the metal shielding layer and the common electrode and is electrically connected with the metal shielding layer by means of the second via.

8. The method of claim 7, wherein after forming the pattern of the source/drain electrode, and before forming the pattern of the common electrode, the method further comprises:
forming a thin film for a second insulating layer between the source/drain electrode and the common electrode to be formed; and
forming a third via penetrating the thin film of the second insulating layer by performing a patterning process, wherein the common electrode is electrically connected with the first connection part by means of the third via.

9. The method of claim 8, further comprising:
at the same time as forming the third via, forming, by performing a patterning process for one time, a fourth via penetrating the second insulating layer;
at the same time as forming the pattern of the common electrode, forming, by performing a patterning process for one time, a pattern of a second connection part which is used for electrically connecting a pixel electrode to be formed and a drain electrode in the source/drain electrode, wherein the second connection part is electrically connected with the drain electrode by means of the fourth via;
after forming the pattern of the common electrode, the method further comprises:
forming a thin film of a third insulating layer on the common electrode;
forming a fifth via penetrating the thin film of the third insulating layer by performing a patterning process; and
forming a pattern of the pixel electrode on the third insulating layer, wherein the pixel electrode is electrically connected with the second connection part by means of the fifth via.

10. The method of claim 7, wherein after forming the pattern of the source/drain electrode, and before forming the pattern of the common electrode, the method further comprises:
forming a thin film for a second insulating layer between the source/drain electrode and the common electrode to be formed;
forming, by performing a patterning process, a sixth via penetrating the thin film of the second insulating layer; and
forming a pattern of a pixel electrode on the thin film of the second insulating layer in which the sixth via has been formed, wherein the pixel electrode is electrically connected with a drain electrode in the source/drain electrode by means of the sixth via.

11. The method of claim 10, further comprising:
at the same time as forming the sixth via, forming, by performing a patterning process for one time, a seventh via penetrating the second insulating layer; and
at the same time as forming the pattern of the pixel electrode, forming, by performing a patterning process for one time, a pattern of a third connection part which is used for electrically connecting the common electrode to be formed and the first connection part, wherein the third connection part is electrically connected with the first connection part by means of the seventh via;
after forming the pattern of the pixel electrode, the method further comprises:
forming a thin film of a third insulating layer between the pixel electrode and the common electrode to be formed; and
forming, by performing a patterning process, an eighth via penetrating the thin film of the third insulating layer, wherein the common electrode to be formed is electrically connected with the third connection part by means of the eighth via.
